# EUROPÄISCHE PATENTANMELDUNG

(11) **EP 2 482 386 A1**
(43) Veröffentlichungstag der Anmeldung: **01.08.2012**
(21) Anmeldenummer: 12000302.5
(22) Anmeldetag: 19.01.2012
(51) Int. Cl.: H01R 12/52, H05K 1/14

(54) **Vorrichtung zur elektrischen und mechanischen Verbindung von zwei übereinander angeordneten Leiterplatten**

(30) Priorität: 26.01.2011 DE 102011009439
(71) Anmelder: Diehl AKO Stiftung & Co. KG, 88239 Wangen im Allgäu (DE)
(72) Erfinder: Bertelsmann, Götz-Martin, 88239 Wangen (DE)
(74) Vertreter: Diehl Patentabteilung

(57) **Zusammenfassung**

Eine Vorrichtung zur elektrischen und mechanischen Verbindung von zwei übereinander angeordneten Leiterplatten (10, 16), wobei eine erste Leiterplatte (10) auf einer einer zweiten Leiterplatte (16) zugewandten Seite wenigstens eine erste Kontaktfläche (14) und/oder auf einer der zweiten Leiterplatte (16) abgewandten Seite wenigstens eine zweite Kontaktfläche (14) aufweist und die zweite Leiterplatte (16) auf einer der ersten Leiterplatte (10) zugewandten Seite wenigstens eine erste Kontaktfläche (18) und/oder auf einer der ersten Leiterplatte (10) abgewandten Seite wenigstens eine zweite Kontaktfläche (20) aufweist, weist eine erste Trägerplatte (22) auf der der zweiten Leiterplatte (16) abgewandten Seite der ersten Leiterplatte (10), eine zweite Trägerplatte (28) auf der der ersten Leiterplatte (10) abgewandten Seite der zweiten Leiterplatte (16) und eine dritte Trägerplatte (38) zwischen der ersten und der zweiten Leiterplatte (10, 16) auf, wobei die erste Trägerplatte (22) und/oder die zweite Trägerplatte (28) und/oder die dritte Trägerplatte (38) zumindest teilweise aus einem elektrisch isolierenden Material bestehen. In einer Ausgestaltung weist die erste Trägerplatte (22) auf ihrer der ersten Leiterplatte (10) zugewandten Seite wenigstens eine Kontaktfläche (24) aus einem elektrisch leitfähigen Material auf und weist die zweite Trägerplatte (28) auf ihrer der zweiten Leiterplatte (16) zugewandten Seite wenigstens eine Kontaktfläche (30) aus einem elektrisch leitfähigen Material auf und weist die Vorrichtung wenigstens ein erstes Verbindungselement (34) zum elektrischen Verbinden der Kontaktfläche (24) der ersten Trägerplatte (22) und der Kontaktfläche (30) der zweiten Trägerplatte (28) auf. Die Verbindungsvorrichtung weist ferner eine Spannvorrichtung (50, 54) auf, um die erste, die zweite und die dritte Trägerplatte (22, 28, 38) mit zumindest Endbereichen der beiden Leiterplatten (10, 16) dazwischen derart zu verbinden, dass die wenigstens eine Kontaktfläche (24) der ersten Trägerplatte (22) mit der wenigstens einen zweiten Kontaktfläche (14) der ersten Leiterplatte (10) in Kontakt ist und die wenigstens eine Kontaktfläche (30) der zweiten Trägerplatte (28) mit der wenigstens einen zweiten Kontaktfläche (20) der zweiten Leiterplatte (16) in Kontakt ist.

## Beschreibung

Die vorliegende Erfindung betrifft eine Vorrichtung zur elektrischen und mechanischen Verbindung von zwei übereinander angeordneten Leiterplatten.

Es besteht Bedarf an einer Verbindungsvorrichtung für übereinander angeordnete Leiterplatten, die gleichzeitig eine elektrische Verbindung und eine mechanische Verbindung der beiden Leiterplatten herstellt. Je nach Anwendungsfall besteht zudem Bedarf an einer solchen Verbindungsvorrichtung, die eine für hohe Spannungen und große Ströme geeignete elektrische Verbindung bei kleinem Verbindungswiderstand bereitstellt.

Herkömmlicherweise werden zwei übereinander angeordnete Leiterplatten miteinander verbunden, indem entsprechende Stecker an die Kontaktflächen der Leiterplatten gelötet werden. Diese Stecker werden je nach Konfiguration direkt oder über ein entsprechendes Verbindungskabel miteinander verbunden. Hierbei treten jedoch im Allgemeinen drei bis fünf Übergangswiderstände zwischen den Kontaktflächen der Leiterplatten und den Steckern, direkt zwischen den beiden Steckern oder zwischen dem Verbindungskabel und den Steckern auf. Dies führt zumeist zu einem hohen Vormontageaufwand und zu großen Verbindungswiderständen an / zwischen den Leiterplatten.

So beschreibt zum Beispiel die DE 10 2006 033 688 A1 ein elektrisches Kontaktierungselement, das als flexibler, U-förmiger Abstandhalter zwischen zwei übereinander angeordneten Leiterplatten ausgebildet ist und an seinen zwei enden jeweils einen Steckerpin zum Einpressen in einen entsprechenden Stecker an den Leiterplatten versehen ist.

Die DE 101 59 113 A1 offenbart eine Leiterplattenanordnung mit zwei übereinander angeordneten Leiterplatten und einem zwischen die Leiterplatten gesetzten Verbindungsrahmen, der einerseits mehrere Positionierstifte und Halteclipse zum positionsgenauen mechanischen Verbinden der beiden Leiterplatten und andererseits mehrere Kontaktbrücken mit zahlreichen Steckerpins zum elektrischen Verbinden der beiden Leiterplatten umfasst.

Die DE 10 2004 041 207 A1 offenbart einen Verbindungskörper zum elektrischen und mechanischen Verbinden von zwei übereinander angeordneten Leiterplatten, der zwischen die zwei Leiterplatten zu setzen ist und mehrere Isolierplatten, mehrere Federhalter zum elektrischen Verbinden der beiden Leiterplatten und mehrere Rastverbinder zum mechanischen Verbinden der beiden Leiterplatten aufweist.

Der Erfindung liegt die Aufgabe zugrunde, eine verbesserte Vorrichtung zur elektrischen und mechanischen Verbindung von zwei übereinander angeordneten Leiterplatten zu schaffen.

Diese Aufgabe wird gelöst durch eine Verbindungsvorrichtung mit den Merkmalen des Anspruchs 1. Vorteilhafte Ausgestaltungen und Weiterbildungen der Erfindung sind Gegenstand der abhängigen Ansprüche.

Die erfindungsgemäße Vorrichtung dient zur elektrischen und mechanischen Verbindung von zwei übereinander angeordneten Leiterplatten, wobei eine erste Leiterplatte auf einer einer zweiten Leiterplatte zugewandten Seite wenigstens eine erste Kontaktfläche und/oder auf einer der zweiten Leiterplatte abgewandten Seite wenigstens eine zweite Kontaktfläche aufweist und die zweite Leiterplatte auf einer der ersten Leiterplatte zugewandten Seite wenigstens eine erste Kontaktfläche und/oder auf einer der ersten Leiterplatte abgewandten Seite wenigstens eine zweite Kontaktfläche aufweist. Die Verbindungsvorrichtung ist gemäß der Erfindung dadurch gekennzeichnet, dass
- sie eine erste Trägerplatte auf der der zweiten Leiterplatte abgewandten Seite der ersten Leiterplatte, eine zweite Trägerplatte auf der der ersten Leiterplatte abgewandten Seite der zweiten Leiterplatte und eine dritte Trägerplatte zwischen der ersten und der zweiten Leiterplatte aufweist, wobei die erste Trägerplatte und/oder die zweite Trägerplatte und/oder die dritte Trägerplatte zumindest teilweise aus einem elektrisch isolierenden Material bestehen;
- die erste Trägerplatte auf ihrer der ersten Leiterplatte zugewandten Seite wenigstens eine Kontaktfläche aus einem elektrisch leitfähigen Material aufweist und die zweite Trägerplatte auf ihrer der zweiten Leiterplatte zugewandten Seite wenigstens eine Kontaktfläche aus einem elektrisch leitfähigen Material aufweist und die Vorrichtung wenigstens ein erstes Verbindungselement zum elektrischen Verbinden der Kontaktfläche der ersten Trägerplatte und der Kontaktfläche der zweiten Trägerplatte aufweist
   und/oder
   die dritte Trägerplatte auf ihrer der ersten Leiterplatte zugewandten Seite wenigstens eine erste Kontaktfläche aus einem elektrisch leitfähigen Material und auf ihrer der zweiten Leiterplatte zugewandten Seite wenigstens eine zweite Kontaktfläche aus einem elektrisch leitfähigen Material aufweist und die Vorrichtung wenigstens ein zweites Verbindungselement zum elektrischen Verbinden der ersten und zweiten Kontaktflächen der dritten Trägerplatte aufweist; und
- sie ferner eine Spannvorrichtung aufweist, um die erste, die zweite und die dritte Trägerplatte mit zumindest Endbereichen der beiden Leiterplatten dazwischen derart zu verbinden, dass die wenigstens eine Kontaktfläche der ersten Trägerplatte mit der wenigstens einen zweiten Kontaktfläche der ersten Leiterplatte in Kontakt ist und die wenigstens eine Kontaktfläche der zweiten Trägerplatte mit der wenigstens einen zweiten Kontaktfläche der zweiten Leiterplatte in Kontakt ist und/oder die wenigstens eine erste Kontaktfläche der dritten Trägerplatte mit der wenigstens einen ersten Kontaktfläche der ersten Leiterplatte in Kontakt ist und die wenigstens eine zweite Kontaktfläche der dritten Trägerplatte mit der wenigstens einen ersten Kontaktfläche der zweiten Leiterplatte in Kontakt ist.

Mit der erfindungsgemäßen Verbindungsvorrichtung erfolgt eine elektrische Verbindung zwischen den Kontaktflächen der beiden übereinander angeordneten Leiterplatten allein durch die Kontaktflächen an den Trägerplatten. Es existieren somit lediglich zwei Übergangswiderstände an den beiden Verbindungen zwischen diesen Trägerplatten-Kontaktflächen und den jeweiligen Kontaktflächen der beiden Leiterplatten. Diese Verbindungsvorrichtung ist damit insbesondere auch für hohe Spannungen und/oder große Ströme geeignet.

Außerdem hat die Verbindungsvorrichtung gemäß der Erfindung einen einfachen Aufbau, insbesondere einen einfachen Aufbau aus wenigen und einfachen Komponenten.

Die elektrische Verbindung und zugleich auch die mechanische Verbindung zwischen den beiden übereinander angeordneten Leiterplatten erfolgt durch das Anordnen der Endbereiche der beiden Leiterplatten zwischen drei Trägerplatten und Verspannen dieser Anordnung in Richtung quer zu den Ebenen der beiden Leiterplatten. Mit Hilfe der erfindungsgemäßen Verbindungsvorrichtung lässt sich auf einfache Weise eine stabile Verbindung zwischen den übereinander angeordneten Leiterplatten erzielen. Durch die Trägerplatten und die entsprechenden großflächigen Verbindungen lässt sich eine stabile mechanische Verbindung der beiden Leiterplatten ohne die Gefahr einer Beschädigung derselben erzielen.

Ferner ist auch der Verbindungsvorgang von zwei Leiterplatten mit Hilfe der erfindungsgemäßen Verbindungsvorrichtung einfach und mit wenigen Schritten durchzuführen.

Je nach Ausführungsform der Verbindungsvorrichtung und je nach Konfiguration der beiden zu verbindenden Leiterplatten können mit der Vorrichtung der Erfindung neben der mechanischen Verbindung der beiden übereinander angeordneten Leiterplatten die folgenden elektrischen Verbindungen hergestellt werden:
- Verbinden der Kontaktflächen auf den einander abgewandten Seiten der beiden Leiterplatten miteinander;
- Verbinden der Kontaktflächen auf den einander zugewandten Seiten der beiden Leiterplatten miteinander; oder
- Verbinden der Kontaktflächen auf den einander abgewandten Seiten der beiden Leiterplatten und der Kontaktflächen auf den einander zugewandten Seiten der beiden Leiterplatten miteinander.

Der Begriff "Leiterplatte" umfasst in diesem Zusammenhang allgemein einen Träger für elektronische Bauteile, der sowohl der mechanischen Befestigung als auch der elektrischen Verbindung dient. Für eine Leiterplatte werden auch die Begriffe Leiterkarte, Platine und gedruckte Schaltung (engl. printed circuit board) verwendet.

Die Verbindung von "zwei Leiterplatten" umfasst in diesem Zusammenhang die Verbindung wenigstens einer ersten Leiterplatte mit wenigstens einer zweiten Leiterplatte. Neben der Verbindung von genau einer ersten Leiterplatte mit genau einer zweiten Leiterplatte können mit Hilfe der erfindungsgemäßen Verbindungsvorrichtungen auch mehrere erste Leiterplatten gleichzeitig mit einer zweiten Leiterplatte, eine erste Leiterplatte gleichzeitig mit mehreren zweiten Leiterplatten und mehrere erste Leiterplatten gleichzeitig mit mehreren zweiten Leiterplatten verbunden werden. Die mehreren ersten bzw. zweiten Leiterplatten sind in diesem Fall vorzugsweise im Wesentlichen koplanar zueinander ausgerichtet und in Richtung quer zur Verbindungsrichtung nebeneinander angeordnet.

Außerdem ist die Vorrichtung der Erfindung gleichermaßen auf die elektrische und mechanische Verbindung von genau zwei übereinander angeordneten Leiterplatten anwendbar und auf die elektrische und mechanische Verbindung von mehr als zwei übereinander angeordneten Leiterplatten erweiterbar.

Die zu verbindenden Leiterplatten sind nicht notwendigerweise gleich dick (in Verbindungsrichtung), gleich groß (in der Ebene quer zur Verbindungsrichtung) und gleich geformt.

Die Anordnung der zwei zu verbindenden Leiterplatten "übereinander" soll alle Anordnungen umfassen, bei denen die Hauptseiten der benachbarten Leiterplatten einander zugewandt sind. Dabei umfasst der Begriff "übereinander" in diesem Zusammenhang insbesondere im Wesentlichen parallele Anordnungen der Leiterplatten.

Unter dem Begriff "Kontaktfläche" einer Leiterplatte soll in diesem Zusammenhang eine Fläche an einer Hauptseite der Leiterplatte verstanden werden, die elektrisch leitfähig ausgebildet ist. Eine solche Kontaktfläche ist üblicherweise mit einer oder mehreren Leiterbahnen in/auf der Leiterplatte verbunden. Eine solche Kontaktfläche dient im Allgemeinen der elektrisch leitfähigen Montage von elektronischen Bauteilen auf der Leiterplatte. Die Befestigung der Bauteile erfolgt dabei zumeist mittels eines Lötverfahrens, die Kontaktflächen werden deshalb häufig auch als Lötflächen oder Lötpads bezeichnet. Die Kontaktflächen bestehen vorzugsweise aus Kupfer oder verzinntem Kupfer. Die Kontaktflächen der Leiterplatten in deren End- oder Kantenbereich können auch als Kantenkontakte bezeichnet werden.

Die "Trägerplatte" ist ein plattenförmiger Körper von grundsätzlich beliebiger Grundform (z.B. Quadrat, Rechteck, Kreis, Ellipsoid, etc.). Die erste, die zweite und die dritte Trägerplatte der Verbindungsvorrichtung sind vorzugsweise elektrisch isolierend ausgebildet. Die beiden Trägerplatten besitzen vorzugsweise eine ausreichende mechanische Festigkeit, um bei dem Verbindungsvorgang mittels der Spannvorrichtung die mechanische und elektrische Verbindung der übereinander angeordneten Leiterplatten zu gewährleisten. Die Trägerplatten sind vorzugsweise so dimensioniert, dass sie die im Wesentlichen übereinander liegenden Endbereiche der beiden Leiterplatten mit den Kontaktflächen überdecken. Ferner sind die Trägerplatten vorzugsweise so dimensioniert, dass sie quer zur Verbindungsrichtung alle Kontaktflächen der ersten Leiterplatte und alle Kontaktflächen der zweiten Leiterplatte, die mittels der Verbindungsvorrichtung elektrisch miteinander verbunden werden sollen, überdecken. Grundsätzlich können die Trägerplatten auch im Wesentlichen die gleiche Breite wie die beiden Leiterplatten haben.

Unter dem Begriff "Kontaktfläche" der Trägerplatte soll in diesem Zusammenhang eine Fläche an einer Hauptseite der Trägerplatte aus einem elektrisch leitfähigen Material (z.B. Metall) verstanden werden. Die Form und die Dicke dieser Kontaktfläche sind grundsätzlich beliebig, sofern sie eine elektrisch leitende Verbindung zwischen den Kontaktflächen der Leiterplatten gewährleisten. Die Kontaktflächen sind vorzugsweise integral mit den jeweiligen Trägerplatten ausgebildet oder fest mit diesen verbunden.

Bei einpoligen Verbindungen zwischen den Leiterplatten und einem isolierenden Gehäuse für die Leiterplatten muss zumindest eine der drei Trägerplatten der Verbindungsvorrichtung nicht elektrisch isolierend sein, d.h. Trägerplatte und Kontaktfläche der Trägerplatte bilden eine Einheit und können aus dem gleichen Material gefertigt sein. Im Fall des Erdleiteranschlusses und eines geerdeten (metallischen) Gehäuses stellt dann vorzugsweise die Spannvorrichtung der Verbindungsvorrichtung auch die elektrische Verbindung zu mindestens einer Kontaktfläche der Leiterplatten bzw. jeder Leiterplatte her.

Der Begriff "Spannvorrichtung" soll in Zusammenhang mit der vorliegenden Erfindung jede Art von Vorrichtung umfassen, die geeignet ist, die drei Trägerplatten der Verbindungsvorrichtung mit den Endbereichen der beiden Leiterplatten dazwischen ausreichend fest miteinander zu verbinden, dass eine elektrische und mechanische Verbindung der beiden Leiterplatten erreicht ist. Die Spannvorrichtung ist vorzugsweise so ausgebildet, dass sie im gelösten Betriebszustand das Einfügen der Endbereiche der Leiterplatten zwischen die drei Trägerplatten der Verbindungsvorrichtung erlaubt und im angezogenen Betriebszustand einen festen Verbund der Leiterplatten mit der Verbindungsvorrichtung bildet. Die Spannvorrichtung verspannt die Trägerplatten der Verbindungsvorrichtung mit den Endbereichen der Leiterplatten dazwischen in einer Richtung im Wesentlichen quer zur Ebene der Leiterplatten. Die Spannvorrichtung dient in diesem Zusammenhang hauptsächlich der mechanischen Verbindung der benachbarten Leiterplatten. Zusätzlich kann die Spannvorrichtung auch eine mechanische Befestigung der so verbundenen Leiterplatten an einem Gehäuse oder dergleichen bewirken.

In einer vorteilhaften Ausgestaltung der Erfindung sind die wenigstens eine Kontaktfläche der ersten Trägerplatte, die wenigstens eine Kontaktfläche der zweiten Trägerplatte, die wenigstens eine erste Kontaktfläche der dritten Trägerplatte und/oder die wenigstens eine zweite Kontaktfläche der dritten Trägerplatte zumindest in einem ihrer der jeweiligen Kontaktfläche der beiden Leiterplatten zugewandten Bereiche zumindest teilweise mit einer strukturierten Oberfläche versehen. Die strukturierte Oberfläche ist vorzugsweise eine Aufrauung, Riffelung oder dergleichen.

In einer weiteren vorteilhaften Ausgestaltung der Erfindung sind die wenigstens eine Kontaktfläche der ersten Trägerplatte, die wenigstens eine Kontaktfläche der zweiten Trägerplatte, die wenigstens eine erste Kontaktfläche der dritten Trägerplatte und/oder die wenigstens eine zweite Kontaktfläche der dritten Trägerplatte zumindest in einem ihrer der jeweiligen Kontaktfläche der beiden Leiterplatten zugewandten Bereiche aus einem Material mit einer höheren Härte als das Material der jeweiligen Kontaktflächen der jeweiligen Leiterplatte gebildet.

Bei Ausführungsformen, bei welchen die beiden vorgenannten Maßnahmen gemeinsam vorgesehen sind, kann sich die strukturierte Kontaktfläche der Trägerplatte in die jeweilige Kontaktfläche der Leiterplatte eindrücken. Auf diese Weise können eine größere Kontaktierungsfläche und als Ergebnis ein extrem kleiner Übergangswiderstand erzielt werden, was zu einer Erhöhung der Stromtragfähigkeit der Verbindung führt.

In einer vorteilhaften Ausgestaltung der Erfindung ist das wenigstens eine erste Verbindungselement zum Verbinden der Kontaktflächen der ersten und der zweiten Trägerplatte zumindest teilweise elastisch ausgebildet. Bei dieser Ausführungsform kann auf einfache Weise ein Lösen und Anziehen der Spannvorrichtung, was eine Längenänderung der Verbindungsvorrichtung in ihrer Verbindungsrichtung zur Folge hat, bei gleichzeitig sicherer elektrischer Verbindung zwischen den Kontaktflächen der ersten und der zweiten Trägerplatte gewährleistet werden.

In einer weiteren vorteilhaften Ausgestaltung der Erfindung ist das wenigstens eine erste Verbindungselement zum Verbinden der Kontaktflächen der ersten und der zweiten Trägerplatte zumindest teilweise mit einer Isolierung aus einem elektrisch isolierenden Material versehen. Vorzugsweise ist diese Isolierung zumindest auf der den Leiterplatten abgewandten Außenseite des ersten Verbindungselements und damit der Außenseite der Verbindungsvorrichtung vorgesehen. Im Fall eines elastischen ersten Verbindungselements ist auch die Isolierung vorzugsweise elastisch ausgebildet.

In einer noch weiteren vorteilhaften Ausgestaltung der Erfindung ist das wenigstens eine zweite Verbindungselement zum Verbinden der ersten und der zweiten Kontaktfläche der dritten Trägerplatte integral mit der ersten und der zweiten Kontaktfläche der dritten Trägerplatte ausgebildet.

In einer vorteilhaften Ausgestaltung der Erfindung ist die dritte Trägerplatte austauschbar. Auf diese Weise können zum Beispiel dritte Trägerplatten mit unterschiedlichen Dicken zwischen die beiden Leiterplatten gesetzt werden, um so den Abstand zwischen den beiden übereinander angeordneten Leiterplatten variabel einzustellen.

Bei der letztgenannten Ausgestaltung der Verbindungsvorrichtung ist insbesondere auch die elastische Ausbildung des wenigstens einen ersten Verbindungselements zum Verbinden der Kontaktflächen der ersten und der zweiten Trägerplatte von Vorteil, um die unterschiedlichen Dimensionierungen der Verbindungsvorrichtung in der Verbindungsrichtung aufgrund der verschiedenen dritten Trägerplatten auszugleichen.

In einer weiteren vorteilhaften Ausgestaltung der Erfindung weist die erste Trägerplatte wenigstens eine Durchgangsbohrung auf und weist die zweite Trägerplatte wenigstens eine Durchgangsbohrung auf und weist die dritte Trägerplatte wenigstens eine Durchgangsbohrung auf, wobei die Durchgangsbohrungen der drei Trägerplatten im Wesentlichen koaxial zueinander ausgerichtet sind. Die Spannvorrichtung weist dann wenigstens eine Schraube auf, die durch die Durchgangsbohrungen in den drei Trägerplatten geführt ist.

Die Schraubverbindung stellt eine besonders einfache Montage der erfindungsgemäßen Verbindungsvorrichtung bereit. Grundsätzlich ist eine einzige Schraube für die Spannvorrichtung ausreichend, mit dem Vorteil einer schnellen Montage, insbesondere bei ausgedehnten Trägerplatten können aber auch zwei oder mehr Schrauben für die Spannvorrichtung vorgesehen sein.

Vorzugsweise wird die wenigstens eine Schraube der Spannvorrichtung auch durch entsprechende Durchgangsbohrungen in den beiden Leiterplatten geführt. Die Durchgangsbohrungen in den Leiterplatten werden vorzugsweise im Wesentlichen koaxial zu den Durchgangsbohrungen in den drei Trägerplatten ausgerichtet. Vorzugsweise befinden sich die Durchgangsbohrungen in den Leiterplatten in diesem Fall im Bereich der Kontaktflächen der Leiterplatten. Aus diesem Grund ist es von Vorteil, die Durchgangsbohrungen in den Leiterplatten als elektrisch isolierte Durchgangsbohrungen auszubilden.

Bei dieser Konfiguration der Spannvorrichtung weist die Vorrichtung vorzugsweise wenigstens ein Isolierelement auf, das zumindest teilweise aus einem elektrisch isolierenden Material besteht und das entsprechend den Durchgangsbohrungen in den drei Trägerplatten angeordnet ist, um die wenigstens eine Schraube gegen die wenigstens eine Kontaktfläche der ersten Trägerplatte und/oder die wenigstens eine Kontaktfläche der zweiten Trägerplatte und/oder die wenigstens eine erste Kontaktfläche der dritten Trägerplatte und/oder die wenigstens eine zweite Kontaktfläche der dritten Trägerplatte zu isolieren. Im Fall einer Schraube aus einem elektrisch isolierenden Material kann wahlweise auch auf diese Isolierelemente verzichtet werden.

Alternativ oder zusätzlich kann die Spannvorrichtung auch Klemmen, welche die Trägerplatten der Verbindungsvorrichtung an ihren Außenumfängen umgreifen, Nieten oder dergleichen aufweisen.

In einer weiteren vorteilhaften Ausgestaltung der Erfindung weist die Vorrichtung wenigstens eine Positioniereinrichtung zum richtigen Positionieren der Vorrichtung relativ zu den beiden Leiterplatten auf. Die Positioniereinrichtung weist vorzugsweise Vorsprünge, Marken, Zähne, Rippen, Federn oder dergleichen auf, die in entsprechende Ausnehmungen, Nuten oder dergleichen in den Leiterplatten eingreifen können, oder umgekehrt. Die Positioniereinrichtung kann auch eine optische Positionierhilfe aufweisen. Weiter ist die Positioniereinrichtung vorzugsweise für beide zu verbindende Leiterplatten vorgesehen. Die Positioniereinrichtung dient vorzugsweise auch als Kodierung, um für bestimmte Leiterplatten die entsprechende Verbindungsvorrichtung auszuwählen und einzusetzen.

In einer noch weiteren Ausgestaltung der Erfindung weist die Vorrichtung ferner wenigstens eine Positionshalteeinrichtung zum Beibehalten einer richtigen Positionierung der Vorrichtung relativ zu den beiden Leiterplatten während eines Montagevorganges der Vorrichtung auf. Die Positionshalteeinrichtung ist vorzugsweise als Verdrehsicherung ausgestaltet.

Die Isolierelemente, die Positioniereinrichtung und die Positionshalteeinrichtung der Verbindungsvorrichtung können wahlweise als verschiedene Komponenten konzipiert sein oder in Zweier- oder Dreierkombinationen als eine Einheit bzw. ein Bauteil ausgebildet sein. In einer vorteilhaften Ausgestaltung der Erfindung können die Isolierelemente, die Positioniereinrichtung und/oder die Positionshalteeinrichtung auch integral mit den Trägerplatten der Verbindungsvorrichtung ausgebildet sein.

In einer weiteren vorteilhaften Ausgestaltung der Erfindung weist die erste Trägerplatte mehrere elektrisch voneinander isolierte Kontaktflächen zum Verbinden mehrerer voneinander isolierter zweiter Kontaktflächen der ersten Leiterplatte auf und/oder weist die zweite Trägerplatte mehrere elektrisch voneinander isolierte Kontaktflächen zum Verbinden mehrerer voneinander isolierter zweiter Kontaktflächen der zweiten Leiterplatte auf und/oder weist die dritte Trägerplatte mehrere elektrisch voneinander isolierte erste Kontaktflächen zum Verbinden mehrerer voneinander isolierter erster Kontaktflächen der ersten Leiterplatte auf und/oder weist die dritte Trägerplatte mehrere elektrisch voneinander isolierte zweite Kontaktflächen zum Verbinden mehrerer voneinander isolierter erster Kontaktflächen der zweiten Leiterplatte auf. Die Kontaktflächen der Verbindungsvorrichtung sind in diesem Fall zum Beispiel streifenförmig ausgebildet und zueinander beabstandet an den Trägerplatten vorgesehen.

Mit Hilfe der Verbindungsvorrichtung der Erfindung können in vorteilhafter Weise auch galvanisch getrennte Potentiale zwischen den benachbarten Leiterplatten übertragen werden.

Die Verbindungsvorrichtung der Erfindung kann in vorteilhafter Weise zum Verbinden von zwei übereinander angeordneten Leiterplatten in einem Solarwechselrichter eingesetzt werden, um eine kostengünstige Verbindung für hohe Spannungen (z.B. 1 kV) und große Ströme (typischerweise mehr als 10 A) zu erzielen, ohne dass die vorliegende Erfindung jedoch auf diese Anwendung beschränkt sein soll.

Die erfindungsgemäße Verbindungsvorrichtung kann grundsätzlich auch eingesetzt werden, um eine Leiterplatte elektrisch und mechanisch an einen Träger, eine Montageplattform oder dergleichen mit entsprechenden Kontaktflächen anzuschließen. Im Sinne der vorliegenden Erfindung soll deshalb ein solcher Träger oder dergleichen auch als zweite Leiterplatte verstanden werden.

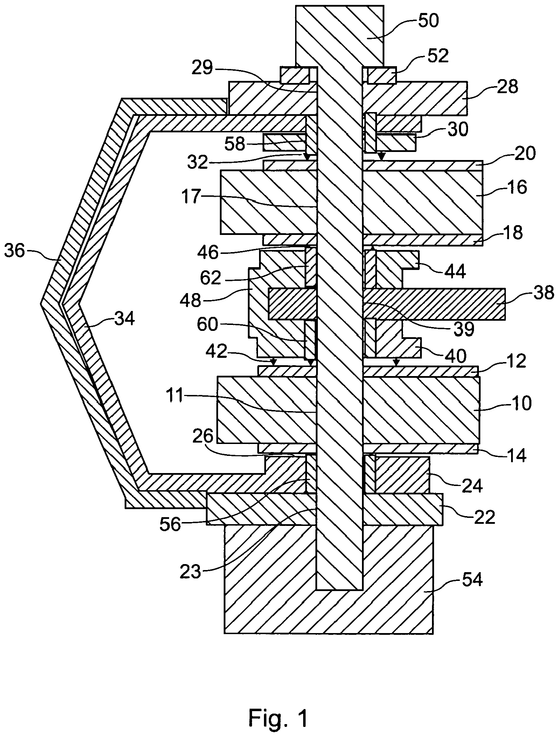

Obige sowie weitere Merkmale und Vorteile der Erfindung werden aus der nachfolgenden Beschreibung eines bevorzugten, nicht-einschränkenden Ausführungsbeispiels unter Bezugnahme auf die beiliegende Zeichnung besser verständlich. Darin zeigt die einzige Figur 1 eine schematische Schnittansicht eines Ausführungsbeispiels einer erfindungsgemäßen Verbindungsvorrichtung.

Figur 1 zeigt die Endbereiche von zwei im Wesentlichen parallel übereinander angeordneten Leiterplatten 10 und 16. Die erste Leiterplatte 10 hat auf ihrer der zweiten Leiterplatte 16 zugewandten Seite (oben in Figur 1) wenigstens eine erste Kontaktfläche 12 und auf ihrer der zweiten Leiterplatte 16 abgewandten Seite (unten in Figur 1) wenigstens eine zweite Kontaktfläche 14. In ähnlicher Weise hat auch die zweite Leiterplatte 16 auf ihrer der ersten Leiterplatte 10 zugewandten Seite (unten in Figur 1) wenigstens eine erste Kontaktfläche 18 und auf ihrer der ersten Leiterplatte 10 abgewandten Seite (oben in Figur 1) wenigstens eine zweite Kontaktfläche 20. Die ersten und zweiten Kontaktflächen 12, 14, 18, 20 der beiden Leiterplatten 10 und 16 bestehen zum Beispiel aus blankem Kupfer oder metallisierten Kontakten (verzinnt, vergoldet, ...).

Die beiden Leiterplatten 10, 16 mit ihren Kontaktflächen 12, 14, 18, 20 in ihren einander zugewandten Endbereichen werden mit Hilfe einer Verbindungsvorrichtung elektrisch und mechanisch miteinander verbunden.

Diese Verbindungsvorrichtung weist eine erste Trägerplatte 22, eine zweite Trägerplatte 28 und eine dritte Trägerplatte 38 auf, wobei die drei Trägerplatten 22, 28, 38 im Wesentlichen parallel zueinander und im Wesentlichen parallel zu den beiden Leiterplatten 10, 16 ausgerichtet sind. Die Trägerplatten 22, 28, 38 bestehen vorzugsweise aus einem elektrisch isolierenden, steifen Material.

An ihren den Leiterplatten 10, 16 zugewandten Seiten sind die drei Trägerplatten 22, 28, 38 (entsprechend der Anzahl der Kontaktflächen 12, 14, 18, 20 der Leiterplatten 10, 16) jeweils mit Kontaktflächen 24, 30, 40, 44 versehen. Diese Kontaktflächen 24, 30, 40, 44 sind elektrisch leitend und sind zum Beispiel aus Metall gefertigt.

Genauer ist in diesem Ausführungsbeispiel von Figur 1 die der ersten Leiterplatte 10 zugewandte Seite der ersten Trägerplatte 22 mit wenigstens einer Kontaktfläche 24 zum Kontaktieren der wenigstens einen zweiten Kontaktfläche 14 der ersten Leiterplatte 10 vorgesehen, ist die der zweiten Leiterplatte 16 zugewandte Seite der zweite Trägerplatte 28 mit wenigstens einer Kontaktfläche 30 zum Kontaktieren der wenigstens einen zweiten Kontaktfläche 20 der zweiten Leiterplatte 16 vorgesehen, ist die der ersten Leiterplatte 10 zugewandte Seite der dritten Trägerplatte 38 mit wenigstens einer ersten Kontaktfläche 40 zum Kontaktieren der wenigstens einen ersten Kontaktfläche 12 der ersten Leiterplatte 10 vorgesehen, und ist die der zweiten Leiterplatte 16 zugewandte Seite der dritten Trägerplatte 38 mit wenigstens einer zweiten Kontaktfläche 44 zum Kontaktieren der wenigstens einen ersten Kontaktfläche 18 der zweiten Leiterplatte 16 vorgesehen.

Um eine elektrische Verbindung zwischen der wenigstens einen zweiten Kontaktfläche 14 der ersten Leiterplatte 10 und der wenigstens einen zweiten Kontaktfläche 20 der zweiten Leiterplatte 16 herzustellen, ist wenigstens ein erstes Verbindungselement 34 vorgesehen, welches die Kontaktflächen 24, 30 der ersten und der zweiten Trägerplatte 22, 28 miteinander elektrisch leitend verbindet. Dieses erste Verbindungselement 34 ist vorzugsweise zumindest teilweise bzw. abschnittweise elastisch ausgebildet.

Zur Vermeidung eines elektrischen Kontakts zum Beispiel mit einem Gerätegehäuse oder allgemein der Umgebung der Leiterplatten 10, 16 ist das erste Verbindungselement 34 mit einer Isolierung 36 versehen, welche vorzugsweise ebenfalls zumindest teilweise bzw. abschnittweise elastisch ausgebildet ist.

Um eine elektrische Verbindung zwischen der wenigstens einen ersten Kontaktfläche 11 der ersten Leiterplatte 10 und der wenigstens einen ersten Kontaktfläche 18 der zweiten Leiterplatte 16 herzustellen, ist wenigstens ein zweites Verbindungselement 48 vorgesehen, welches die ersten und zweiten Kontaktflächen 40, 44 der dritten Trägerplatte 38 miteinander elektrisch leitend verbindet.

Das erste Verbindungselement 34 ist vorzugsweise integral mit den Kontaktflächen 24, 30 der ersten bzw. der zweiten Trägerplatte 22, 28 ausgebildet und das zweite Verbindungselement 48 ist vorzugsweise integral mit den ersten und zweiten Kontaktflächen 40, 44 der dritten Trägerplatte 38 ausgebildet.

Vorzugsweise sind die Kontaktflächen 24, 30, 40, 44 an den Trägerplatten 22, 28, 38, welche die ersten bzw. zweiten Kontaktflächen 12, 14, 18, 20 der beiden Leiterplatten 10, 16 kontaktieren sollen, strukturiert ausgebildet (z.B. aufgeraut) 26, 32, 42, 46. Außerdem sind die Kontaktflächen 24, 30, 40, 44 an den Trägerplatten 22, 28, 38 vorzugsweise aus einem härteren Material gefertigt als die Kontaktflächen 12, 14, 18, 20 der Leiterplatten 10, 16. Auf diese Weise werden die Oberflächenstrukturen 26, 32, 42, 46 der härteren Kontaktflächen 24, 30, 40, 44 an den Trägerplatten 22, 28, 38 in die weicheren Kontaktflächen 12, 14, 18, 20 der Leiterplatten 10, 16 beim Anziehen der Spannvorrichtung, die nachfolgend näher beschrieben wird, eingedrückt. Dies führt zu einer großflächigeren und sichereren Kontaktierung und damit zu einer Reduzierung der Übergangswiderstände an diesen Verbindungsstellen, was die Stromtragfähigkeit aufgrund des verringerten Übergangswiderstandes erhöht.

In dem Ausführungsbeispiel von Figur 1 sind die Kontaktflächen 24, 30, 40, 44 an den Trägerplatten 22, 28, 38 jeweils gestuft ausgebildet. Die Kontaktflächen 24, 30, 40, 44 können aber ebenso im Wesentlichen plan ausgebildet sein.

Die drei Trägerplatten 22, 28, 38 sind jeweils im Bereich ihrer Kontaktflächen 24, 30, 40, 44 mit einer Durchgangsbohrung 23, 29 bzw. 39 versehen, wobei diese Durchgangsbohrungen 23, 29, 39 im Wesentlichen koaxial zueinander ausgerichtet sind. Außerdem sind die beiden Leiterplatten 10, 16 jeweils im Bereich ihrer ersten und zweiten Kontaktflächen 12, 14, 18, 20 mit einer Durchgangsbohrung 11 bzw. 17 ausgebildet. Die Durchgangsbohrungen 11, 17 der Leiterplatten 10, 16 werden im Wesentlichen koaxial zueinander und im Wesentlichen koaxial zu den Durchgangsbohrungen 23, 29, 39 in den drei Trägerplatten 22, 28, 38 der Verbindungsvorrichtung ausgerichtet.

Durch die oben beschriebenen Durchgangsbohrungen 11, 17, 23, 29, 39 der beiden Leiterplatten 10, 16 und der drei Trägerplatten 22, 28, 38 ist quer zu den Ebenen der Leiterplatten 10, 16 (d.h. in Oben/Unten-Richtung in Figur 1) eine Schraube 50 geführt. Der Schraubenkopf der Schraube 50 stützt sich über eine Tellerscheibe, eine Unterlegscheibe 52, einen Zahnring, einen Federring oder dergleichen an der zweiten Trägerplatte 28 ab, während das Gewinde der Schraube 50 in ein Gewinde in einem Bodenteil 54 (z.B. in der Art einer Schraubenmutter oder als Teil eines Gerätegehäuses ausgebildet) eingreift, auf dem sich die erste Trägerplatte 22 abstützt. Alternativ kann das Gewinde, in welches die Spannschraube 50 eingreift, auch in der ersten Trägerplatte 22 selbst ausgebildet sein.

Die Schraube 50 und das Bodenteil 54 bilden die Spannvorrichtung der Verbindungsvorrichtung. Beim Anziehen der Schraube 50 werden die drei Trägerplatten 22, 28, 38 aufeinander zu bewegt und damit jeweils auch in Richtung auf die zwischengesetzten Endbereiche der beiden Leiterplatten 10, 16 zu bewegt. Die beiden Leiterplatten 10, 16 werden auf diese Weise durch die Verbindungsvorrichtung mechanisch fixiert.

Um eine elektrische Kontaktierung der üblicherweise metallischen Schraube 50 durch die Kontaktflächen 24, 30, 40, 44 an den Trägerplatten 22, 28, 38 zu verhindern, sind an den Trägerplatten 22, 28, 38 im Bereich der Durchgangsbohrungen 23, 29, 39 vorzugsweise kragen- bzw. hülsenförmige Isolierelemente 56, 58, 60 bzw. 62 aus einem elektrisch isolierenden Material angebracht oder angeformt.

Diese Isolierelemente 56, 58, 60, 62 können zudem als Positionierelemente und Positionshalteelemente dienen, indem sie zum Beispiel mit Vorsprüngen in entsprechende Nuten in den Leiterplatten 10, 16 eingreifen, um die Verbindungsvorrichtung relativ zu den Leiterplatten 10, 16 so zu positionieren, dass die gewünschte(n) elektrische(n) Verbindung(en) zwischen den beiden Leiterplatten 10, 12 hergestellt werden und alle Durchgangsbohrungen 11, 17, 23, 29, 39 koaxial zueinander ausgerichtet sind. Mit Hilfe solcher Positionierelemente 56, 58, 60, 62 kann auch eine Art Kodierung der Verbindungsvorrichtung erfolgen, sodass für vorgegebene Leiterplatten 10, 16 mit bestimmten Anzahlen und Anordnungen von Kontaktflächen 12, 14, 18, 20 jeweils die richtige Verbindungsvorrichtung mit passenden Kontaktflächen 24, 30, 40, 44 ausgewählt wird. Schließlich können diese Isolierelemente 56, 58, 60, 62 auch als Verdrehsicherung fungieren, um die richtige Positionierung der Verbindungsvorrichtung relativ zu den beiden Leiterplatten 10, 16 während des Montageprozesses, insbesondere während des Anziehens der einen Schraube 50 aufrechtzuerhalten.

In einer alternativen Ausgestaltung können die Positionierelemente und Positionshalteelemente auch als separate Komponenten zu den Isolierelementen 56, 58, 60, 62 ausgebildet sein.

Die dritte Trägerplatte 38 mit ihren Kontaktflächen 40, 44 und Verbindungselementen 48 ist vorzugsweise austauschbar in der oben beschriebenen Verbindungsvorrichtung angeordnet. So können je nach gewünschtem Abstand zwischen den zwei Leiterplatten 10, 16 und je nach Vorhandensein, Größe und Anzahl der ersten Kontaktflächen 12, 18 der beiden Leiterplatten 10, 16 die passenden dritten Trägerplatten 38 eingesetzt werden. Mit anderen Worten ist die Verbindungsvorrichtung der Erfindung diesbezüglich frei konfigurierbar.

### BEZUGSZIFFERNLISTE

- 10: erste Leiterplatte
- 11: Durchgangsbohrung in erster Leiterplatte
- 12: erste Kontaktfläche der ersten Leiterplatte
- 14: zweite Kontaktfläche der ersten Leiterplatte
- 16: zweite Leiterplatte
- 17: Durchgangsbohrung in zweiter Leiterplatte
- 18: erste Kontaktfläche der zweiten Leiterplatte
- 20: zweite Kontaktfläche der zweiten Leiterplatte
- 22: erste Trägerplatte
- 23: Durchgangsbohrung in erster Trägerplatte
- 24: Kontaktfläche der ersten Trägerplatte
- 26: Oberflächenstruktur von 24
- 28: zweite Trägerplatte
- 29: Durchgangsbohrung in zweiter Trägerplatte
- 30: Kontaktfläche der zweiten Trägerplatte
- 32: Oberflächenstruktur von 30
- 34: erstes Verbindungselement
- 36: Isolierelement
- 38: dritte Trägerplatte
- 39: Durchgangsbohrung in dritter Trägerplatte
- 40: erste Kontaktfläche der dritten Trägerplatte
- 42: Oberflächenstruktur von 40
- 44: zweite Kontaktfläche der dritten Trägerplatte
- 46: Oberflächenstruktur von 44
- 48: zweites Verbindungselement
- 50: Schraube
- 52: Unterlegscheibe
- 54: Bodenteil mit Gewinde
- 56: Isolierelement der ersten Trägerplatte
- 58: Isolierelement der zweiten Trägerplatte
- 60: erstes Isolierelement der dritten Trägerplatte
- 62: zweites Isolierelement der dritten Trägerplatte

## Patentansprüche

1. Vorrichtung zur elektrischen und mechanischen Verbindung von zwei übereinander angeordneten Leiterplatten (10, 16), wobei eine erste Leiterplatte (10) auf einer einer zweiten Leiterplatte (16) zugewandten Seite wenigstens eine erste Kontaktfläche (14) und/oder auf einer der zweiten Leiterplatte (16) abgewandten Seite wenigstens eine zweite Kontaktfläche (14) aufweist und die zweite Leiterplatte (16) auf einer der ersten Leiterplatte (10) zugewandten Seite wenigstens eine erste Kontaktfläche (18) und/oder auf einer der ersten Leiterplatte (10) abgewandten Seite wenigstens eine zweite Kontaktfläche (20) aufweist,
**dadurch gekennzeichnet, dass**
- die Vorrichtung eine erste Trägerplatte (22) auf der der zweiten Leiterplatte (16) abgewandten Seite der ersten Leiterplatte (10), eine zweite Trägerplatte (28) auf der der ersten Leiterplatte abgewandten Seite der zweiten Leiterplatte (16) und eine dritte Trägerplatte (38) zwischen der ersten und der zweiten Leiterplatte (10, 16) aufweist, wobei die erste Trägerplatte (22) und/oder die zweite Trägerplatte (28) und/oder die dritte Trägerplatte (38) zumindest teilweise aus einem elektrisch isolierenden Material bestehen;
- die erste Trägerplatte (22) auf ihrer der ersten Leiterplatte (10) zugewandten Seite wenigstens eine Kontaktfläche (24) aus einem elektrisch leitfähigen Material aufweist und die zweite Trägerplatte (28) auf ihrer der zweiten Leiterplatte (16) zugewandten Seite wenigstens eine Kontaktfläche (30) aus einem elektrisch leitfähigen Material aufweist und die Vorrichtung wenigstens ein erstes Verbindungselement (34) zum elektrischen Verbinden der Kontaktfläche (24) der ersten Trägerplatte (22) und der Kontaktfläche (30) der zweiten Trägerplatte (28) aufweist
die dritte Trägerplatte (38) auf ihrer der ersten Leiterplatte (10) zugewandten Seite wenigstens eine erste Kontaktfläche (40) aus einem elektrisch leitfähigen Material und auf ihrer der zweiten Leiterplatte (16) zugewandten Seite wenigstens eine zweite Kontaktfläche (44) aus einem elektrisch leitfähigen Material aufweist und die Vorrichtung wenigstens ein zweites Verbindungselement (48) zum elektrischen Verbinden der ersten und zweiten Kontaktflächen (40, 44) der dritten Trägerplatte (38) aufweist; und
- die Vorrichtung eine Spannvorrichtung (50, 54) aufweist, um die erste, die zweite und die dritte Trägerplatte (22, 28, 38) mit zumindest Endbereichen der beiden Leiterplatten (10, 16) dazwischen derart zu verbinden, dass die wenigstens eine Kontaktfläche (24) der ersten Trägerplatte (22) mit der wenigstens einen zweiten Kontaktfläche (14) der ersten Leiterplatte (10) in Kontakt ist und die wenigstens eine Kontaktfläche (30) der zweiten Trägerplatte (28) mit der wenigstens einen zweiten Kontaktfläche (20) der zweiten Leiterplatte (16) in Kontakt ist und/oder die wenigstens eine erste Kontaktfläche (40) der dritten Trägerplatte (38) mit der wenigstens einen ersten Kontaktfläche (12) der ersten Leiterplatte (10) in Kontakt ist und die wenigstens eine zweite Kontaktfläche (44) der dritten Trägerplatte (38) mit der wenigstens einen ersten Kontaktfläche (18) der zweiten Leiterplatte (16) in Kontakt ist.

2. Verbindungsvorrichtung nach Anspruch 1,
**dadurch gekennzeichnet, dass**
die wenigstens eine Kontaktfläche (24) der ersten Trägerplatte (22), die wenigstens eine Kontaktfläche (30) der zweiten Trägerplatte (28), die wenigstens eine erste Kontaktfläche (40) der dritten Trägerplatte (38) und/oder die wenigstens eine zweite Kontaktfläche (44) der dritten Trägerplatte (38) zumindest in einem ihrer der jeweiligen Kontaktfläche (12, 14, 18, 20) der beiden Leiterplatten (10, 16) zugewandten Bereiche zumindest teilweise mit einer strukturierten Oberfläche (26, 32, 42, 46) versehen sind.

3. Verbindungsvorrichtung nach Anspruch 1 oder 2,
**dadurch gekennzeichnet, dass**
die wenigstens eine Kontaktfläche (24) der ersten Trägerplatte (22), die wenigstens eine Kontaktfläche (30) der zweiten Trägerplatte (28), die wenigstens eine erste Kontaktfläche (40) der dritten Trägerplatte (38) und/oder die wenigstens eine zweite Kontaktfläche (44) der dritten Trägerplatte (38) zumindest in einem ihrer der jeweiligen Kontaktfläche (12, 14, 18, 20) der beiden Leiterplatten (10, 16) zugewandten Bereiche aus einem Material mit einer höheren Härte als das Material der jeweiligen Kontaktflächen (12, 14, 18, 20) der jeweiligen Leiterplatte (10, 16) gebildet sind.

4. Verbindungsvorrichtung nach einem der vorhergehenden Ansprüche,
**dadurch gekennzeichnet, dass**
das wenigstens eine erste Verbindungselement (34) zum Verbinden der Kontaktflächen (24, 30) der ersten und der zweiten Trägerplatte (22, 28) zumindest teilweise elastisch ausgebildet ist.

5. Verbindungsvorrichtung nach einem der vorhergehenden Ansprüche,
**dadurch gekennzeichnet, dass**
das wenigstens eine erste Verbindungselement (34) zum Verbinden der Kontaktflächen (24, 30) der ersten und der zweiten Trägerplatte (22, 28) zumindest teilweise mit einer Isolierung (36) aus einem elektrisch isolierenden Material versehen ist.

6. Verbindungsvorrichtung nach einem der vorhergehenden Ansprüche,
**dadurch gekennzeichnet, dass**
das wenigstens eine zweite Verbindungselement (48) zum Verbinden der ersten und der zweiten Kontaktfläche (40, 44) der dritten Trägerplatte (38) integral mit der ersten und der zweiten Kontaktfläche (40, 44) der dritten Trägerplatte (38) ausgebildet ist.

7. Verbindungsvorrichtung nach einem der vorhergehenden Ansprüche,
**dadurch gekennzeichnet, dass**
die dritte Trägerplatte (38) austauschbar ist.

8. Verbindungsvorrichtung nach einem der vorhergehenden Ansprüche,
**dadurch gekennzeichnet, dass**
die erste Trägerplatte (22) wenigstens eine Durchgangsbohrung (23) aufweist und die zweite Trägerplatte (28) wenigstens eine Durchgangsbohrung (29) aufweist und die dritte Trägerplatte (38) wenigstens eine Durchgangsbohrung (39) aufweist, wobei die Durchgangsbohrungen (23, 29, 39) der drei Trägerplatten (22, 28, 38) im Wesentlichen koaxial zueinander ausgerichtet sind; und
die Spannvorrichtung (50, 54) wenigstens eine Schraube (50) aufweist, die durch die Durchgangsbohrungen (23, 29, 39) in den drei Trägerplatten (22, 28, 38) geführt ist.

9. Verbindungsvorrichtung nach Anspruch 8,
**dadurch gekennzeichnet, dass**
die Vorrichtung wenigstens ein Isolierelement (56, 58, 60, 62) aufweist, das zumindest teilweise aus einem elektrisch isolierenden Material besteht und das entsprechend den Durchgangsbohrungen (23, 29, 39) in den drei Trägerplatten (22, 28, 38) angeordnet ist, um die wenigstens eine Schraube (50) gegen die wenigstens eine Kontaktfläche (24) der ersten Trägerplatte (22) und/oder die wenigstens eine Kontaktfläche (30) der zweiten Trägerplatte (28) und/oder die wenigstens eine erste Kontaktfläche (40) der dritten Trägerplatte (38) und/oder die wenigstens eine zweite Kontaktfläche (44) der dritten Trägerplatte (38) zu isolieren.

10. Verbindungsvorrichtung nach einem der vorhergehenden Ansprüche,
**dadurch gekennzeichnet, dass**
die Vorrichtung wenigstens eine Positioniereinrichtung zum richtigen Positionieren der Vorrichtung relativ zu den beiden Leiterplatten (10, 16) aufweist.

11. Verbindungsvorrichtung nach einem der vorhergehenden Ansprüche,
**dadurch gekennzeichnet, dass**
die erste Trägerplatte (22) mehrere elektrisch voneinander isolierte Kontaktflächen (24) zum Verbinden mehrerer voneinander isolierter zweiter Kontaktflächen (14) der ersten Leiterplatte (10) aufweist und/oder die zweite Trägerplatte (28) mehrere elektrisch voneinander isolierte Kontaktflächen (30) zum Verbinden mehrerer voneinander isolierter zweiter Kontaktflächen (20) der zweiten Leiterplatte (16) aufweist und/oder die dritte Trägerplatte (38) mehrere elektrisch voneinander isolierte erste Kontaktflächen (40) zum Verbinden mehrerer voneinander isolierter erster Kontaktflächen (12) der ersten Leiterplatte (10) aufweist und/oder die dritte Trägerplatte (38) mehrere elektrisch voneinander isolierte zweite Kontaktflächen (44) zum Verbinden mehrerer voneinander isolierter erster Kontaktflächen (18) der zweiten Leiterplatte (16) aufweist.
